Europäisches Patentamt

European Patent Office

Office européen des brevets

(11) Veröffentlichungsnummer: **0 078 337**
**B1**

(12) **EUROPÄISCHE PATENTSCHRIFT**

(45) Veröffentlichungstag der Patentschrift:
22.04.87

(51) Int. Cl.⁴: **H 01 L 23/48, H 01 L 21/60**

(21) Anmeldenummer: 81109371.5

(22) Anmeldetag: 30.10.81

(54) **Kontakteinrichtung zur lösbaren Verbindung elektrischer Bauteile.**

(43) Veröffentlichungstag der Anmeldung:
**11.05.83 Patentblatt 83/19**

(45) Bekanntmachung des Hinweises auf die Patenterteilung:
**22.04.87 Patentblatt 87/17**

(84) Benannte Vertragsstaaten:
**DE FR GB IT**

(56) Entgegenhaltungen:
**US - A - 3 525 146**

**MICROELECTRONICS, Band 3, Nr. 4, April 1970, Seiten 32-35, Luton, GB; M.E. HUTTON: "Beam lead technology"**
**JOURNAL OF THE ELECTROCHEMICAL SOCIETY, Band 127, Nr. 12, Dezember 1980, Seiten 2750-2754, Princeton, USA; R.D. JOLLY et al.: "Miniature cantilever beams fabricated by anisotropic etching of silicon"**
**ELECTRONIC DESIGN, Nr. 4, 15. Februar 1978, Seiten 36-37, Rochelle Park, USA; "IC accelerometer-so tiny, it monitors the heart from within"**
**IEEE TRANSACTIONS ON ELECTRON DEVICES, Band ED-25, Nr. 10, Oktober 1978, Seiten 1241-1250, New York, USA; K.E. PETERSEN: "Dynamic micromechanics on silicon: Techniques and devices"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Bohlen, Harald, Geleener Strasse 26, D-7030 Böblingen (DE)**
Erfinder: **Greschner, Johann, Dr., Zollernstrasse 14, D-7401 Pliezhausen 2 (DE)**
Erfinder: **Kaus, Gerhard, Dr., Talstrasse 56, D-7031 Mötzingen 1 (DE)**
Erfinder: **Keyser, Joachim Hermann, Am Killberg 9, D-7277 Wildberg 4 (DE)**
Erfinder: **Kulcke, Werner, Dr., Westerwaldweg 8, D-7030 Böblingen (DE)**

(74) Vertreter: **Herzog, F. Joachim, Dipl.-Ing, Schönaicher Strasse 220, D-7030 Böblingen (DE)**

# Beschreibung

Die Erfindung betrifft eine Kontakteinrichtung zur lösbaren Verbindung elektrischer Bauteile gemäss dem Oberbegriff des Anspruchs 1 sowie ein Verfahren zu ihrer Herstellung.

Lösbare Steckverbindungen, bei denen Leiterzugstifte eines Bauteils zwischen Federkontakte des mit ihm zu verbindenden zweiten Bauteils geschoben werden, sind allgemein bekannt. Für eine niederohmige, erschütterungsunempfindliche sogenannte Steckverbindung dieser Art müssen die Federkontakte einen hohen Kontaktdruck von z.B. 10 kp/cm$^2$ ~ 100 N/cm$^2$ aufweisen, und eine Resonanzfrequenz besitzen, die hoch gegenüber den durch mechanische Erschütterungen anregbaren Frequenzen, also hoch gegenüber beispielsweise 10 kHz liegt. Solche Kontakte lassen sich in Dimensionen, die kleiner als einige mm sind, praktisch nicht herstellen. Sie sind dabei für viele Arten von Verbindungen, insbesondere Vielfachverbindungen wie sie in der modernen Elektronik zunehmend benötigt werden, nicht geeignet.

Eine Kontakteinrichtung zur lösbaren Verbindung elektrischer Bauteile, bei der keine Stifte in Federkontakte eingesteckt werden, ist aus der DDR Patentschrift 77 525 bekannt. Bei dieser bekannten Vielfachkontakteinrichtung sind eine Reihe von eng beieinanderliegenden federnden Drahtkontakten vorgesehen, die durch eine kammartige seitliche Führung in Position gehalten werden. Zur Kontaktherstellung werden diese Federdrähte in einem spitzen Winkel schräg auf die zu kontaktierenden Anschlussleitungen aufgesetzt, wobei sie unter einer schleifenden Bewegung in leicht verbogenem Zustand den Kontakt herstellen. Es ist klar, dass sich Drähte nicht in der genügenden Weise verkleinern lassen, dass sie für die Anwendung bei Elektronikbauteilen von den Abmessungen her geeignet sind.

Bei zunehmender Miniaturisierung müssen die Leiterzugverbindungen Dimensionen aufweisen, die beispielsweise erheblich kleiner als 1 mm sind. Anforderungen dieser Art können bis zu einer Grösse von etwa 0,5 mm durch Lötverbindungen ausgeführt werden. Diese Lötverbindungen sind jedoch starr und haben den schwerwiegenden Nachteil, dass sie nicht lösbar sind.

Die Erfindung, wie sie in den Ansprüchen gekennzeichnet ist, löst die Aufgabe, eine lösbare Kontakteinrichtung mit flexiblen, lagestabilen Kontaktfingern in bisher nicht bekannten kleinen Abmessungen zur Verfügung zu stellen, die für den Einsatz in der modernen Elektronik geeignet und Voraussetzung sind.

Die durch die Erfindung erreichten Vorteile sind im wesentlichen darin zu sehen, dass die aus Silizium bestehenden Kontaktfinger und ihr sie tragendes Verbindungsteil genügend klein, positionsstabil und flexibel hergestellt werden können, dass die zu verbindenden Leiterzugbreiten weit unterhalb des Bereiches von 1 oder ½ Millimeter liegen. Zur Herstellung sind ausgereifte Verfahren und Methoden der Halbleitertechnologie in vorteilhafter Weise leicht anwendbar. Die Kontaktfinger können beispielsweise in Dicken und Breiten von jeweils nur einigen Mikrometern und in Längen in der Grössenordnung von Millimetern hergestellt sein, wobei der Kontaktwiderstand im Bereich von einigen 10 Ohm liegt, die erreichbaren Kontaktdrucke etwa 100 N/cm$^2$ betragen und die Resonanzfrequenzen oberhalb von 10 kHz liegen.

Die Herstellung von mechanischen Bauteilen aus Silizium ist für sich betrachtet an sich nicht neu. So ist beispielsweise in der GE-OS 2 227 342 die Herstellung eines sehr feinen Musters von Öffnungen in Silizium beschrieben, wobei das Silizium als Trägermaterial in sehr dünner Schicht verwendet wird. Weiterhin ist in dem Artikel im IBM Technical Disclosure Bulletin, Vol. 14, No. 2, Juli 1971, Seiten 417 und 418 ein Verfahren beschrieben, um Siliziummasken herzustellen, die Fenster enthalten.

In der DE-OS 2 555 462 ist ein Verfahren beschrieben, mit dessen Hilfe in einem monokristallinen Siliziumplättchen Düsenlöcher mit einem Durchmesser von ca. 25 µm hergestellt werden können. Dabei können einzelne oder eine Vielzahl eng beieinanderliegender Düsen hergestellt werden, die beispielsweise bei Tintenstrahldruckern Anwendung finden. Die Düsen werden durch Anwendung von Ätztechnik bei verschieden dotierten Schichten hergestellt.

Bei diesen bekannten aus Silizium hergestellten Bauteilen sind mechanisch gesehen die Öffnungen jeweils in das Siliziummaterial eingebracht, d.h. das Siliziummaterial umgibt die Öffnungen, so dass kein freitragendes Teil herausgearbeitet wurde. Darüberhinaus erfüllen diese bekannten aus Silizium hergestellten Bauteile keine Funktion zur Leitung elektrischen Stroms, um damit elektrische Bauteile bzw. Schaltkreise miteinander zu verbinden.

Im folgenden wird die Erfindung anhand der lediglich einen Ausführungsweg darstellenden Zeichnung in Aufbau und Funktionsweise näher erläutert. Darin zeigt:

Fig. 1 eine Seitenansicht der erfindungsgemässen Kontakteinrichtung;

Fig. 2 eine Draufsicht auf die in Fig. 1 dargestellte, erfindungsgemäss gestaltete Kontakteinrichtung und

Fig. 3A–E schematisch verschiedene Schritte bei der Herstellung der erfindungsgemässen Kontakteinrichtung, teilweise in Seitenansicht und teilweise in Draufsicht.

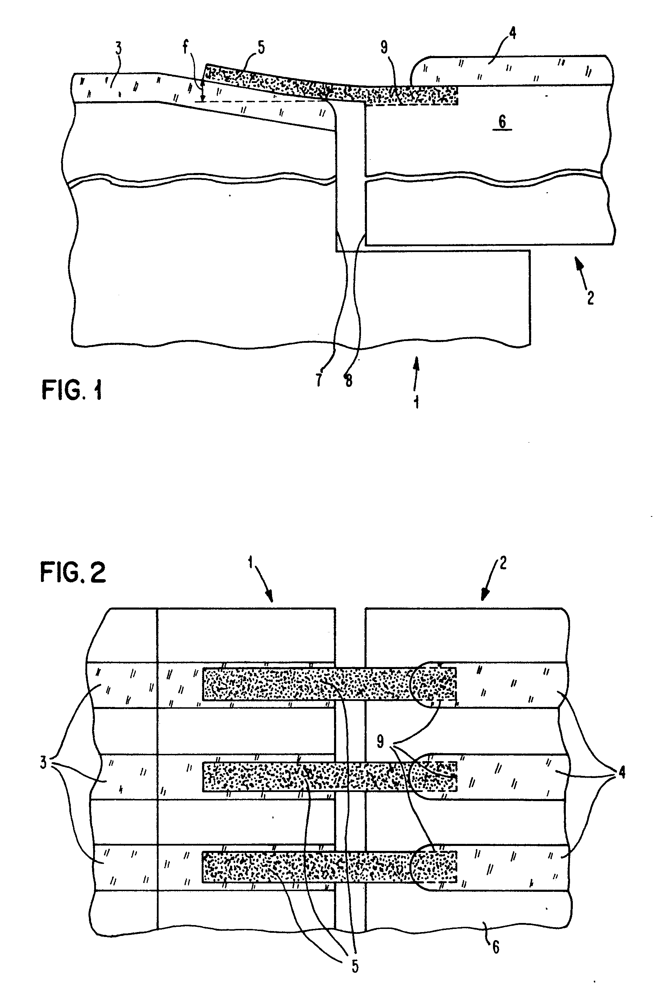

Fig. 1 und 2 zeigen in Seitenansicht bzw. in Draufsicht zwei miteinander zu verbindende elektrische Bauteile 1 und 2. Das Bauteil 1 ist mit mehreren Leiterzügen 3 versehen, die im dargestellten Bereich zueinander parallel verlaufen. Ebenso ist das zweite Bauteil 2 mit elektrischen Leiterzügen 4 versehen. Der Abstand zwischen den Leiterzügen 3 bzw. 4 ist im Verbindungsbereich im wesentlichen der gleiche. Zur Verbindung der beiden Bauteile 1 und 2 bzw. zur Verbindung der auf ihnen vorgesehenen Leiterzüge 3 und 4 sind erfindungsgemäss an dem einen Bauteil 2 vorspringende Finger 5 im Abstand der Leiterzuge 3 bzw. 4 vorgesehen. Die Finger 5 sind über ein Rückenteil 6 miteinander verbunden und vorteilhafterweise einstückig aus dem Substrat bzw. Trägermaterial des Bauteils 2 herausgearbeitet. Das Bauteil 1 weist eine winklige Ausnehmung 7 auf, in die eine dimensionsmässig entsprechend gestaltete Ecke 8 des Rückenteils 6 eingreift. Die Leiterzüge 3 des Bauteils 1 sind im Bereich der Kontaktierung mit den Fingern 5 abgeschrägt, wie dies Fig. 1 zeigt. Werden beide Bauteile 1 und 2 durch nicht dargestellte Halterungen so ineinandergebracht, dass die Ecke 8 des Rückenteils 6 in die entsprechend geformte Ausnehmung 7 des Bauteils 1 eingreift, so ruhen die Finger 5 auf den schrägen Teilen der Leiterzüge 3 in der Art, dass sie sich um einen Betrag f durchbiegen. Durch diese Durchbiegung der Finger 5 wird der für die Kontaktierung notwendige Kontaktdruck aufgebracht. Die die beiden Bauteile 1 und 2 zusammenhaltenden Halterungen sind in den Fign. nicht dargestellt.

Gemäss der Erfindung sind die Finger 5 aus Silizium hergestellt, ebenso wie der sie tragende Rückenteil 6. Vorteilhaft ist dabei, wenn die Finger 5 und das Rückenteil 6 einstückig hergestellt sind, d.h. dass die Finger 5 aus einem Siliziumsubstrat zusammen mit dem Rückenteil 6 herausgearbeitet worden sind. Dabei wird dem Siliziummaterial, welches den Finger 5 bildet eine derartige Leitfähigkeit verliehen, dass eine möglichst niederohmige Verbindung zwischen den Leiterzügen 3 des Bauteils 1 und den Leiterzügen 4 des Bauteils 2 zustande kommt. Eine derartige Leitfähigkeit der Finger 5 lässt sich mittels einer hochdotierten, gut leitenden Siliziumschicht erreichen. Zur Dotierung wird vorzugsweise Bor in einer Konzentration von ca. $10^{19}$–$10^{20}$ Atome/cm$^3$ verwendet.

Die Breite b der Finger 5 wird zweckmässigerweise kleiner gewählt als es dem Abstand zwischen zwei Leiterzügen 3 bzw. 4 entspricht, damit bei einem falschen Aufsetzen der Finger 5 auf das andere zu kontaktierende Bauteil 1 sichergestellt ist, dass durch die Finger 5 kein Kurzschluss zwischen zwei benachbarten Leiterzügen 3 dieses Bauteils 1 entstehen kann.

Wie aus den Fign. 1 und 2 hervorgeht, übergreifen die Leiterzüge 4 des Bauteils 2 die elektrisch leitenden Bereiche der Finger 5, dargestellt durch die gestrichelte Linie 9 in der Fig. 2. Dadurch, dass nur die Siliziumbereiche der Finger 5 hochdotiert bzw. elektrisch gut leitend sind, ist sichergestellt, dass zwischen den Leiterzügen 4 des Bauteils 2, welches mit den Kontaktfingern 5 versehen ist, keine Kurzschlüsse möglich sind.

Die Herstellung des Rückenteils 6 mit den daran befindlichen biegsamen Kontaktfingern 5 erfolgt in vorteilhafter Weise durch Anwendung von mikromechanischer Silizium-Halbleitertechnologie.

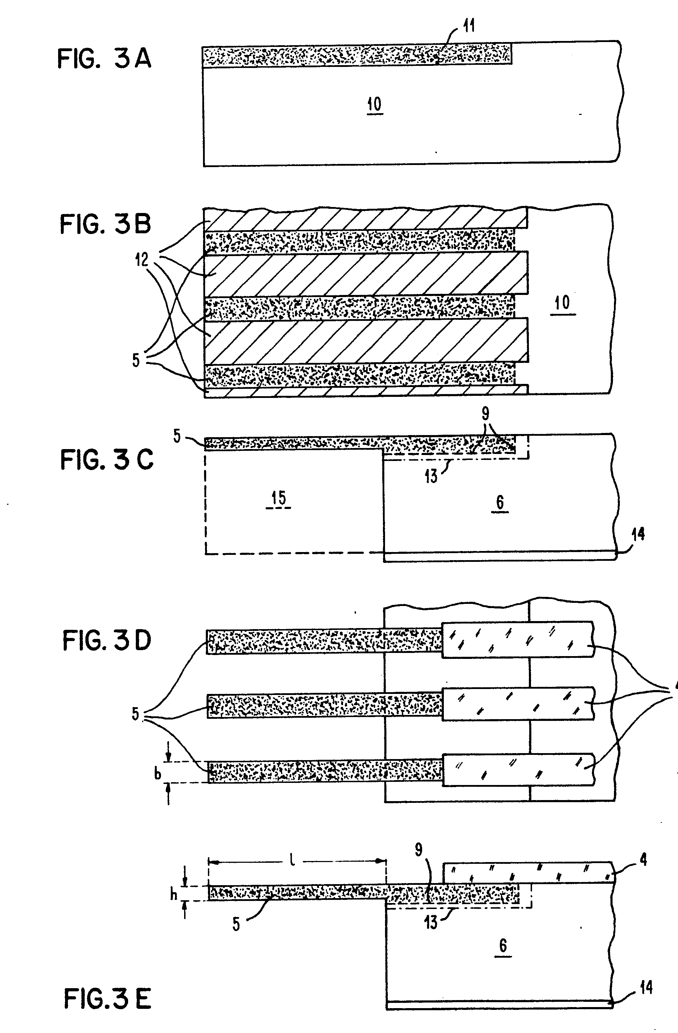

Ein vorteilhaftes Herstellungsverfahren wird nachfolgend anhand der Fig. 3 dargestellt. In ein monokristallines Siliziumsubstrat 10 wird eine elektrisch leitende Schicht 11 eingebracht, beispielsweise durch Dotierung des Substrats 10 mit etwa $10^{20}$ Boratomen/cm$^3$. Diese Schicht 11 wird im Bereich der Finger so weit eingebracht, wie es entsprechend der Darstellung in Fig. 1 und 2 nötig ist, damit die leitenden Bereiche, angedeutet durch die gestrichelte Linie 9 bis unter die Leiter 4 des Bauteils 2 hineinreichen. Das Siliziumsubstrat 10 ist in Fig. 3A abgebrochen dargestellt, womit angedeutet werden soll, dass der Teil mit den Fingern und dem Rücken 6 Teil eines Bauteils 2 ist, beispielsweise einer integrierten Schaltung, die als Substrat das bereits genannte Substrat 10 aufweist und in welches die interessierenden elektrischen Schaltkreise in Halbleitertechnologie eingebracht sind. Ein näheres Eingehen auf diese Schaltkreise erübrigt sich in dem hiesigen Zusammenhang. Die leitende Schicht 11, mit Bor hochdotiertes Silizium, wird in einer Dicke in das Substrat 10 eingebracht, die um einige μm die spätere Dicke h der Finger 5 übersteigt. Diese elektrisch leitfähige Schicht 11 ist in Fig. 3A im Querschnitt dargestellt und ihre Grenze in anderen Fign. durch die gestrichelte Linie 9 angedeutet.

Nach photolithographischer Strukturierung werden, wobei eine SiO$_2$-Schicht als Zwischenmaske verwendet wird, aus der mit Bor hochdotierten Schicht 11 die Zwischenräume 12 zwischen den Fingern 5 herausgeätzt. Dieses Herausätzen der Zwischenräume 12 erfolgt tiefenmässig um einige μm über die Tiefe der mit Bor hochdotierten Schicht 11 hinaus bis in das undotierte Material des Siliziumsubstrats 10 hinein. Dadurch ist sichergestellt, dass die mit Bor dotierten Bereiche 11 jetzt streifenförmig bereits die Fingerform aufweisen, wie dies in Fig. 3B erkennbar ist, so dass zwischen den elektrisch leitenden Bereichen keine Verbindung besteht. Die Strukturierung der mit Bor hochdotierten Schicht 11 bzw. das Versehen mit den Zwischenräumen 12 erfolgt durch anisotropes reaktives Ionenätzen in Ar/Cl$_2$-Atmosphäre. Die Fig. 3B zeigt das Ergebnis dieser Strukturierung in Draufsicht. Die tiefenmässige Absetzung der Ausnehmungen 12 und der mit Bor hochdotierten Schicht 11 lässt sich beispielsweise aus den Fign. 3C und 3E erkennen, wobei dort die Grenze der mit Bor hochdotierten Schicht 11 durch die gestrichelte Linie 9 dargestellt ist und die Tiefe der Ausnehmungen 12 durch die strichpunktierte Linie 13 dargestellt ist.

Die Rückseite bzw. Unterseite des Siliziumsubstrats 10 wird anschliessend mit einer SiO$_2$-Schicht 14 abgedeckt bis auf den Bereich, den die Finger 5 anschliessend über das Substrat 10 bzw. den Rückenteil 6 in freier Auskragung vorstehen sollen, d.h. also bis auf die Länge l der Finger. Das freie, undotierte Silizium des Substrats 10 wird danach bis auf die mit Bor hochdotierte Schicht 11 hin abgeätzt, d.h. bis in den Bereich der Finger 5 hinein, wie dies der Fig. 3C zu entnehmen ist, in der der gestrichelte Bereich 15 das wegzuätzende undotierte und nicht abgedeckte Silizium bezeichnet. Dieses Ätzen erfolgt z.B. durch anisotropes, preferentielles Nassätzen mit Äthylendiamin, Brenzcatechin und Wasser.

Nach Herstellen der Ausnehmungen 12, dargestellt in Fig. 3B und danach erfolgtem Entfernen undotierten Siliziums im Bereich 15, dargestellt in Fig. 3C, bleibt als Ergebnis übrig eine Struktur von einer Reihe parallel nebeneinanderliegender, frei vom Rückenteil 6 bzw. Substrat 10 vorkragender Finger 5 bestimmter Breite b, Länge l und Dicke h. Dieses Ergebnis ist in Draufsicht in Fig. 3D und in Seitenansicht Fig. 3E dargestellt.

In den Fign. 3D und 3E sind die anschliessend auf die Herstellung der Finger erfolgte Aufbringung der Leiterzüge 4 dargestellt, die einen Grossteil der hochdotierten, streifenförmigen elektrisch leitende Bereiche übergreifen, die mit dem Bezugszeichen 9 in Fig. 3C und 3E angedeutet sind. Dort, wo die Leiterzüge 4 und die elektrisch leitenden Bereiche 11 sich überlappen, wird zwischen beiden der elektrische Kontakt hergestellt.

Durch die hohe Bordotierung des Siliziumsubstrats 10 in den Bereichen 11 sind die elektrischen Widerstände der Finger 5 sehr gering. Bei einer Bordotierung von $10^{20}$ Atomen/cm$^3$ hat das Silizium einen spezifischen Widerstand von nur $\rho \cong 10^{-3}$ Ohm · cm. Aufgrund dieses Widerstandswertes, der klein genug für die vorgesehenen Anwendungen erscheint, ist der Einsatz als Verbindungskontakt möglich. Aus diesen Gründen allein müssen im Hinblick auf die Leitfähigkeit die Finger nicht zusätzlich mit einem metallischen Belag versehen werden, dieser kann jedoch aus Gründen der Elastizität unter Umständen günstig sein.

Die erfindungsgemäss gestaltete Kontakteinrichtung zeigt in Fig. 3E beispielsweise den unausgelenkten Finger 5 mit einer Länge l, einer Dicke h und einer Breite b (vergl. Fig. 3D). Dieselbe Anordnung ist in Fig. 1 in der Stellung dargestellt, in der der Finger um den Betrag f aus seiner Ruhelage verbogen ist. Die Durchbiegung f darf ein höchstzulässiges Mass nicht überschreiten. Die maximale Durchbiegung $f_{MAX}$ ist durch die zulässige maximale Biegespannung des Siliziums gegeben.

Eine typische beispielhafte Dimensionierung einer aus Silizium gefertigten Kontakteinrichtung gemäss der Erfindung, wie sie in den Figuren dargestellt ist, ergibt nach den Beziehungen des einseitig eingespannten Balkens, der an seiner Spitze mit einer Kraft F bzw. einem Kontaktdruck $P = F/b^2$ beaufschlagt ist, für die Durchbiegung f an dem freien, äussersten Ende des Fingers 5:

$$f = 4 \frac{1}{E} \frac{l^3}{h^3} b\, P$$

und für die maximale Durchbiegung

$$f_{MAX} = \frac{2}{3} \frac{l^2}{h} \frac{k_B}{E}$$

Der maximale Kontaktdruck $P_{MAX}$ ergibt sich zu

$$P_{MAX} = \frac{1}{6} \frac{h^2}{b l} k_B$$

der bei der Dicken- bzw. Höhenabmessung h, der Breitenabmessung b und der Längenabmessung l bei der zulässigen Biegespannung $k_B$ des Siliziums erreicht werden kann. Dabei ist die Kontaktfläche, auf welcher der Kontaktdruck P wirkt, mit $b^2$ definiert.

Eine weitere Kenngrösse, die wegen der Kontaktierung von Bedeutung ist, ist die Schwingungszahl n der Kontaktfeder 5, die sich nach der Grundschwingung eines einseitig eingespannten prismatischen Stabes aus einem Material des spezifischen Gewichtes $\gamma$ ergibt zu

$$n = 5.05 \sqrt{\frac{E}{\gamma}} \cdot \frac{h}{l^2}$$

Bei den vorstehend genannten Gleichungen bedeuten:
f die Durchbiegung des äussersten Endes des Fingers,
l die Länge des Fingers,
b die Breite des Fingers,
h die Dicke des Fingers,
F die am äussersten Ende des Fingers angreifende Kraft,
$P = F/b^2$ der Kontaktdruck zwischen Finger und kontaktiertem Leiterzug,
E der Elastizitätsmodul,
$k_B$ die zulässige Biegespannung,
$f_{MAX}$ die maximale Durchbiegung vor Bruch.

Der elektrische Widerstand R der Kontaktfinger beträgt

$$R = \rho \frac{l}{b h}$$

wobei $\rho$ der spezifische Widerstand des Materials ist.

Bei dem verwendeten Silizium mit einer Dotierung von $10^{20}$ Boratomen/cm$^3$ ergeben sich folgende Materialkonstanten:

$k_B = 3 \cdot 10^4$ N/cm$^2$
$E = 1.7 \cdot 10^7$ N/cm$^2$
$\gamma = 2.7 \cdot 10^{-2}$ N/cm$^3$
$\rho = 10^{-3} \Omega \cdot$ cm,

dabei bedeutet 1 N = 1 Newton ~ 0,1 kp.

Aus den vorstehend genannten Werten ergeben sich für zwei Ausführungsbeispiele folgende Werte für verschieden gestaltete Kontaktfinger 5:

1. $l = 3 \cdot 10^{-2}$ cm = 0.3 mm    $P_{MAX}$ = 170 N/cm$^2$
    $b = 1 \cdot 10^{-3}$ cm = 10 µm    $f_{MAX}$ = 10 µm
    $h = 1 \cdot 10^{-3}$ cm = 10 µm    n = 140 kHz
                                   R = 30 $\Omega$

2. $l = 2 \cdot 10^{-1}$ cm = 2 mm    $P_{MAX}$ = 500 N/cm$^2$
    $b = 5 \cdot 10^{-3}$ cm = 50 µm    $f_{MAX}$ = 47 µm
    $h = 1 \cdot 10^{-2}$ cm = 100 µm    n = 32 kHz
                                   R = 4 $\Omega$

Vorstehende Werte von Ausführungsbeispielen zeigen, dass die Dimensionierung der Finger entsprechend den vorkommenden Leiterzugbreiten und Anwendungsgebieten optimal auf den jeweiligen Anwendungsfall abgestimmt werden kann. Es ist dabei sicherlich von eminent grosser Bedeutung, dass ein Bauteil integrierter Technologie, basierend auf monokristallinem Silizium als Ausgangsmaterial, seine eigenen Anschlusskontakte in Form der erfindungsgemäss gestalteten Siliziumfinger hat, über die es mit anderen elektrischen Bauteilen bzw. deren Leiterzüge verbunden und mit ihnen kontaktiert werden kann.

**Patentansprüche**

1. Kontakteinrichtung zur lösbaren Verbindung elektrischer Bauteile (1, 2) enthaltend einen oder eine Reihe eng beieinanderliegender federnder Kontakte, dadurch gekennzeichnet, dass jeder Kontakt als einstückiger Finger (5) ausgebildet ist und zusammen mit einem tragenden Rückenteil (6) aus monokristallinem Silizium besteht.

2. Kontakteinrichtung nach Anspruch 1, dadurch gekennzeichnet, dass Finger (5) und Rückenteil (6) einstückig aus monokristallinem Silizium bestehen.

3. Kontakteinrichtung nach Anspruch 1 oder 2, dadurch gekennzeichnet, dass die Finger (5) aus einer elektrisch gut leitenden Siliziumschicht (11) bestehen.

4. Kontakteinrichtung nach Anspruch 3, dadurch gekennzeichnet, dass die elektrisch gut leitende Siliziumschicht (11) mit Bor in einer Konzentration von vorzugsweise ca. $10^{19}$–$10^{20}$ Boratomen/cm$^3$ hochdotiert ist.

5. Kontakteinrichtung nach einem der vorigen Ansprüche, dadurch gekennzeichnet, dass die Breite (b) der Finger (5) kleiner als der Abstand der zu kontaktierenden Leiterzüge (3, 4) ist.

6. Kontakteinrichtung nach einem der vorigen Ansprüche, dadurch gekennzeichnet, dass der aus Fingern (5) und Rückenteil (6) bestehende Teil in mikromechanischer Silizium-Halbleitertechnologie hergestellt ist.

7. Verfahren zur Herstellung einer Kontakteinrichtung gemäss einem der vorigen Ansprüche, dadurch gekennzeichnet, dass in ein Siliziumsubstrat (10) eine elektrisch gut leitende Schicht (11), vorzugsweise mit Bor in einer Konzentration von ca. $10^{19}$–$10^{20}$ Atomen/cm$^3$ hochdotiert, eingebracht wird in einer Dicke, die geringfügig grösser als die gewünschte Dicke (h) der Finger (5) ist, unter Verwendung einer SiO$_2$-Zwischenmaske eine photolithographische Strukturierung der Bereiche der Finger (5) erfolgt, die Zwischenräume (12) zwischen den Fingern (5) tiefenmässig (13) bis über die hochdotierte Schicht (11) hinaus in das undotierte Silizium des Substrats (10) durch anisotropes reaktives Ionenätzen in Ar/Cl$_2$-Atmosphäre weggeätzt wird, anschliessend die Rückseite des Siliziumsubstrats (10) teilweise mit einer SiO$_2$-Schicht abgedeckt und das undotierte Silizium im nichtabgedeckten Bereich (15) bis zur hochdotierten Schicht (11) hin durch anisotropes, preferentielles Nassätzen mit Äthylendiamin, Brenzcatechin und Wasser entfernt wird.

**Claims**

1. Contact device for releasably connecting electrical components (1, 2) containing one or a series of closely adjacent resilient contacts, characterized in that each contact is designed as a one-piece finger (5) and together with a carrying back part (6) consists of monocrystalline silicon.

2. Contact device as claimed in claim 1, characterized in that finger (5) and back part (6) are made in one piece of monocrystalline silicon.

3. Contact device as claimed in claim 1 or 2, characterized in that the fingers (5) are made of an electrically well-conductive silicon layer (11).

4. Contact device as claimed in claim 3, characterized in that the electrically well-conductive silicon layer (11) is highly doped with boron in a concentration of preferably approximately $10^{19}$–$10^{20}$ boron atoms/cm$^3$.

5. Contact device as claimed in any one of the preceding claims, characterized in that the width (b) of the fingers (5) ist smaller than the distance between the conductor lines (3, 4) to be contacted.

6. Contact device as claimed in any one of the preceding claims, characterized in that the part consisting of fingers (5) and back part (6) is made in accordance with micromechanical silicon semiconductor technology.

7. Method of making a contact device as claimed in any one of the preceding claims, characterized in that into a silicon substrate (10) an electrically well-conductive layer (11) is introduced, preferably highly doped with boron in a concentration of approximately $10^{19}$–$10^{20}$ atoms/cm$^3$, in a thickness which is slightly higher than the desired thickness (h) of the fingers (5), using an SiO$_2$ intermediate mask a photolithographic structurization of the regions of the fingers (5) is performed, the spaces (12) between the fingers (5) are etched off (13) depth-wise all through the highly doped layer (11) into the undoped silicon of the substrate (10) by using anisotropic reactive ion etching in an Ar/Cl$_2$-atmosphere, subsequently the back of the silicon substrate (10) is partly covered with an SiO$_2$-layer, and the undoped silicon in the uncovered region (15) is removed into the highly doped layer (11) by using anisotropic, preferential wet etching with ethylene diamine, pyrocatechol, and water.

**Revendications**

1. Dispositif de contact pour connecter de façon séparable des composants électriques (1, 2) contenant un ou une série de contacts élastiques étroitement adjacents, caractérisé en ce que chaque contact est agencé sous forme d'un doigt d'une seule pièce (5) et se compose, ainsi qu'une partie arrière (6) qui le supporte, de silicium monocristallin.

2. Dispositif de contact tel que revendiqué dans la revendication 1, caractérisé en ce que le doigt (5) et la partie arrière (6) sont formés d'une seule pièce de silicium monocristallin.

3. Dispositif de contact tel que revendiqué dans la revendication 1 ou 2, caractérisé en ce que les doigts (5) sont formés d'une couche de silicium électriquement bon conducteur (11).

4. Dispositif de contact tel que revendiqué dans la revendication 3, caractérisé en ce que la couche de silicium électriquement bon conducteur (11) est fortement dopée avec du bore en concentration de préférence approximativement comprise entre $10^{19}$–$10^{20}$ atomes de bore/cm$^3$.

5. Dispositif de contact tel que revendiqué dans une quelconque des revendications précédentes, caractérisé en ce que la largeur (b) des doigts (5) est plus petite que la distance entre les lignes conductrices (3, 4) avec lesquelles le contact doit être établi.

6. Dispositif de contact tel que revendiqué dans une quelconque des revendications précédentes, caractérisé en ce que la partie comportant les doigts (5) et la partie arrière (6) est réalisée conformément à la technologie micro mécanique des semi-conducteurs en silicium.

7. Procédé de fabrication d'un dispositif de contact tel que revendiqué dans une quelconque des revendications précédentes, caractérisé en ce qu'on crée dans un substrat en silicium (10) une couche (11) électriquement bonne conductrice, de préférence fortement dopée avec du bore en concentration approximativement comprise entre $10^{19}$–$10^{20}$ atomes/cm$^3$, avec une épaisseur qui est légèrement supérieure à l'épaisseur désirée h des doigts (5), une structuration photolithographique des zones des doigts (5) est effectuée en utilisant un masque intermédiaire en SiO$_2$, les espaces (12) entre les doigts (5) sont enlevés par gravure (13) sur toute la profondeur de la couche fortement dopée (11) jusqu'au silicium non dopé du substrat (10) en utilisant une gravure anisotrope avec ions réactifs dans une atmosphère de Ar/Cl$_2$, ensuite l'arrière du substrat en silicium (10) est partiellement recouvert d'une couche de SiO$_2$ et le silicium non dopé se trouvant dans la zone non couverte (15) est enlevé jusqu'à la couche fortement dopée (11) en utilisant une gravure anisotrope, préférentielle en voie humide, au moyen d'éthylène diamine, de pyrocatéchine et d'eau.

FIG. 1

FIG. 2

FIG. 3 A

11

10

FIG. 3 B

12

5

10

FIG. 3 C

5

9

13

15

6

14

FIG. 3 D

5

b

9

4

4

FIG. 3 E

l

9

h

4

5

13

6

14